# EUROPEAN PATENT APPLICATION

(11) **EP 0 875 993 A2**
(43) Date of publication of application: **04.11.1998**
(21) Application number: 98106684.8
(22) Date of filing: 11.04.1998
(51) Int. Cl.: H03J 7/00

(54) **AFT optimizing method and apparatus and AFT method for a broadcast receiving system**

(30) Priority: 30.04.1997 KR 9716571
(71) Applicant: DAEWOO ELECTRONICS CO., LTD, Seoul (KR)
(72) Inventor: Jeong, Byoung-Chul, Kyeongki-Do, Korea (KR)
(74) Representative: Dr. Weitzel & Partner

(57) **Abstract**

An AFT optimizing method, apparatus thereof and an AFT method for a broadcast receiving system. A detecting section receives a tuner input signal and detects maximum and minimum voltages of an AFT signal, an adding section adds the maximum and minimum voltages of the AFT signal, an attenuating section attenuates an added signal and outputs an attenuated signal, a comparing section compares the attenuated signal with an AFT reference voltage transmitted from an outside thereof and outputs a comparing signal, and a data processing section transforms the comparing signal into a digital signal and stores the digital signal into a memory. At an initial state, an AFT voltage deviations and times about all channels are optimized and stored in the memory. During a channel switch, the latest stored AFT optimal data is connected, an optimal signal of a selected channel is detected and the AFT is carried out so that the channel switch is quickly carried out and a swing of an image occurring during the channel switch is avoided.

## Description

The present invention relates to an automatic fine tuning (AFT) optimizing method, an apparatus for performing the same and an AFT method of a broadcast receiving system, and more particularly to an AFT optimizing method, and apparatus for performing the same in which an optimal state of a deviation and a time according to a voltage are stored so that a tuner is connected to an optimal channel data during a channel switch of the tuner, thereby preventing an output image from swing according to a swing of a channel data, and an AFT method of a broadcast receiving system using the same.

Presently, a broadcast receiving system includes a circuitry for generating an analog AFT signal. A polarity and an amplitude of the analog AFT signal are those of a frequency deviation between a nominal frequency of a signal and a frequency of an image carrier wave which is an amplitude modulated from an IF signal. The AFT signal is transmitted to a local oscillator of a tuner of the broadcast receiving system, thereby decreasing the frequency deviation of the IF image carrier wave.

Typically, the AFT signal is used for compensating a drift of the local oscillator signal due to a temperature and an aging. Instead of the AFT signal, a closed loop phase and a frequency fixed tuning system are used for fixing the local oscillator signal to a reference signal (the frequency mixing tuning system is well known in the art). However, typically, the AFT signal is applied to the frequency mixing tuning system and is used to compensate the frequency deviation of the IF image carrier wave which is due to a corresponding frequency offset between an image carrier wave of a RF signal supplied by a television signal sources such as an audio system, a video tape player, a video disc player, a personal computer or a camera, and a nominal frequency provided as a carrier reference.

Although an AFT signal generating circuitry includes components such as a filter for reducing a level deviation of the AFT due to an amplitude modulation of a video carrier wave corresponding to an image data, and an amplitude trimming element, a little level deviation of the AFT signal under some circumstances may produce undesirable results.

Generally, a VCR system which is a broadcast receiving system records video and audio signals supplied from regular broadcasting programs or external sources to a magnetic tape and reproduces the video image through the television set. The VCR system has a deck including a mechanism of various driving systems, and a circuit board including a microprocessor as a control system which is installed at a lower portion of the deck.

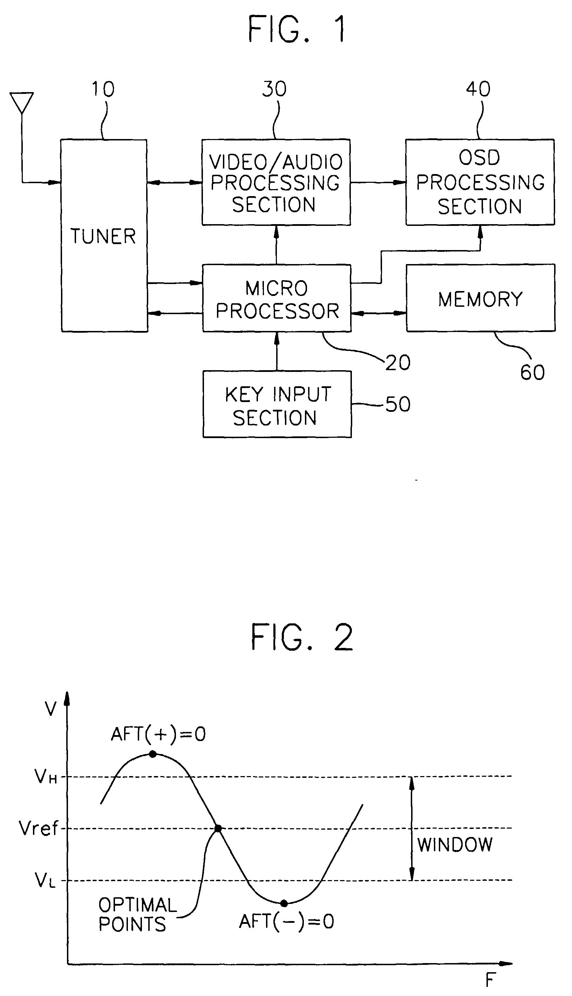

FIG. 1 is a block diagram showing a schematic structure of a conventional broadcast receiving system.

As shown in FIG. 1, the broadcasting receiving system includes a tuner 10, a microprocessor 20, a video/audio processing section 30, an On-Screen-Display (OSD) processing section 40, a key input section 50, and a memory 60.

In detail, tuner 10 receives a number of television channels through an antenna (ANT) and tunes a desired channel from the received channels. Audio/video processing section 30 detects video and audio signals respectively by a video processing IC from the selected channel signal from the tuner 10 and outputs the same. Key input section 50 carries out an interface operation with a user.

Also, microprocessor 20 controls operations of various components of the broadcast receiving system according to a key signal selectively inputted by the user at key input section 50, provides a frequency tuning voltage to tuner 10 so as to select a channel of a desired frequency band, carries out an AFT operation by using a detected voltage from audio/video processing section 30, and simultaneously generates an OSD control signal so as to display an OSD picture for guiding the user through a video signal output terminal.

Also, memory 60 stores various system driving programs and data about an operation control of microprocessor 20 into a chip such as an electrically erasable programmable read only memory (EEPROM).

Also, OSD processing section 40 generates a character information which is to be displayed on a screen according to a control signal of microprocessor 20.

However, in the conventional VCR system, after a channel selection is finished, when there is a selective operation such as a channel switch, a power on/off or an input change which change an operational mode to signal sources which are not synchronized with each other, and since the television set must be tuned to a new signal, the AFT voltage oscillates, which results in an image reproducing swing instantly due to an interference. Also, hundreds of milli-seconds are required to stabilize the image by diminishing the image interference.

Accordingly, in an apparatus used in a special field such as a studio, the signals to be switched are synchronized before they are switched. However, the cost for circuitry increases, so the synchronization of the signals is not adequate in a household television set and the interference occurs when the channel switching is unavoidable.

The present invention is intended to overcome the above described disadvantages. Therefore, it is a first object of the present invention to provide an AFT optimizing method for optimizing a deviation and a time about an AFT voltage during a channel switch of a tuner.

In addition, it is a second object of the present invention to provide an AFT optimizing apparatus for carrying out the AFT optimizing method.

Furthermore, it is a third object of the present invention to provide an AFT optimizing method for a broadcast receiving system for readily carrying out the AFT by adopting the AFT optimizing apparatus to the broadcast receiving system.

In order to achieve the first object of the present invention, there is provided an AFT optimizing method, which is comprised of:
(i) receiving an AFT signal;
(ii) detecting a maximum voltage and a minimum voltage of the received AFT signal;
(iii) determining an AFT optimal signal by data-processing the maximum and minimum voltages detected in step (ii); and
(iv) storing the AFT optimal signal by digital-processing the AFT optimal signal.

Also, in order to achieve the second object of the present invention, there is provided an AFT optimizing apparatus, which is comprised of:
a detecting means for detecting a maximum voltage and a minimum voltage of an AFT signal after receiving a tuner input signal;
an AFT optimal signal detecting means for detecting an AFT optimal signal by receiving the maximum and minimum voltages of the AFT signal transmitted from the detecting means;
a data processing means for data processing the AFT optimal signal transmitted from the AFT optimal signal detecting means into a digital signal; and
a memory for storing the digital signal which is data processed by the data processing means.

Further still, in order to achieve the third object of the present invention, an AFT method is provided for broadcast receiving systems, which is comprised of:
(I) storing AFT optimal data about channels detected by carrying out an AFT to all channels of a broadcasting signal received when a power is turned on;
(II) tuning a selected channel when a channel switch is carried out;
(III) carrying out an AFT optimization to the selected channel when an AFT signal is inputted;
(IV) tuning the selected channel using a detected AFT optimal data; and
(V) replacing an AFT optimal data stored in a memory with the detected AFT optimal data.

The AFT optimizing method and apparatus according to the present invention can reduce a time required to optimize the deviation of the AFT voltage and to minimize the AFT voltage deviation by the detecting section and the AFT optimal signal detecting section of the AFT optimizing apparatus, thereby preventing an image from swing during the channel switch and accordingly, stabilizing the image.

The above object and other advantages of the present invention will become more apparent by describing in detail a preferred embodiment thereof with reference to the attached drawings in which:
FIG. 1 is a block diagram illustrating a schematic structure of a conventional broadcast receiving system;
FIG. 2 is a graph showing an AFT signal voltage level;
FIG. 3 is a block diagram illustrating an AFT optimizing apparatus according to one embodiment of the present invention;
FIG. 4 is a flowchart illustrating an AFT optimal signal detecting process which is carried out by scanning an AFT signal voltage level;
FIG. 5 is a flowchart illustrating the AFT optimal signal detecting process by an integration of the AFT signal about a time;
FIG. 6 is a block diagram illustrating a preferred embodiment of the AFT optimizing apparatus used in a broadcast receiving system according to the present invention; and
FIG. 7 is a flowchart illustrating an image stabilizing method used during a channel switch when the AFT optimizing apparatus according to the present invention is used in the broadcast receiving system.

Hereinafter, an AFT optimizing method and apparatus therefor according to a preferred embodiment of the present invention will be explained in more detail with reference to the accompanying drawings.

Generally, an AFT signal level is compared with fixed upper and lower critical levels which define a frequency range or a window corresponding to a proper tuning.

FIG. 2 is a graph showing an AFT signal voltage level.

As shown in FIG. 2, a window is a frame defining a predetermined area with predetermined critical levels V_{H} and V_{L} centered with a reference voltage Vref of the AFT signal level. Hereinafter, a point at which a differentiation (or a slope) of the AFT signal with time is changed from positive to negative is referred to as AFT(+) and a point at which a differentiation (or a slope) of the AFT signal with time is changed from negative to positive is referred to as AFT(-).

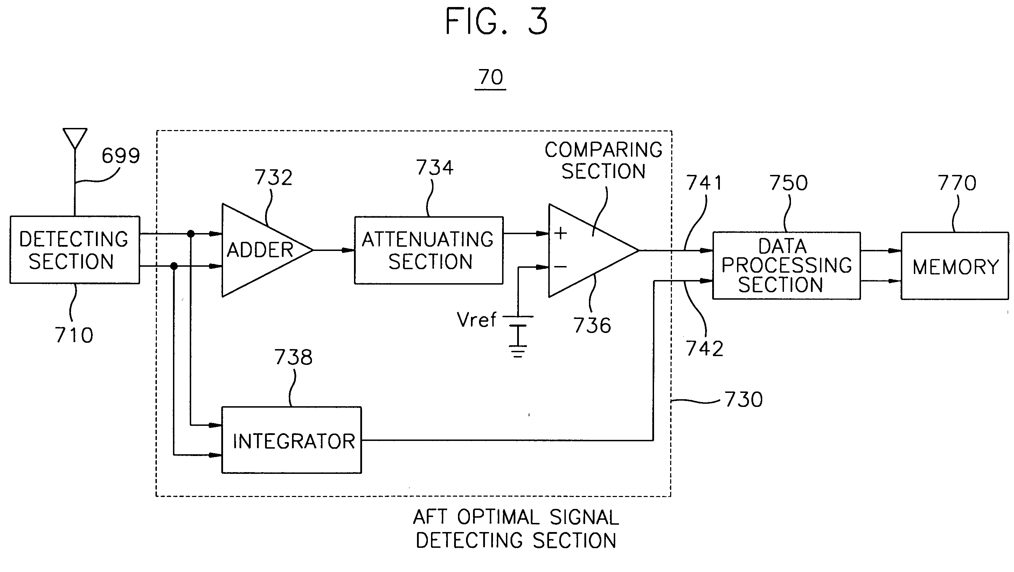

FIG. 3 is a block diagram illustrating an AFT optimizing apparatus which carries out a channel memory function according to one embodiment of the present invention.

As shown in FIG. 3, AFT optimizing apparatus 70 has a detecting section 710, an AFT optimal signal detecting section 730, a data processing section 750 and a memory 770.

Detecting section 710 includes a differentiator, detects voltage points at which a differentiation of a tuner input signal 699 are zero and provides the voltage points to AFT optimal signal detecting section 730. At this time, the tuner input signal 699 is received by a broadcast receiving antenna, a cable distribution network, a direct broadcasting satellite system, a video tape player, a video disc player, a personal computer or a video game player.

AFT optimal signal detecting section 730 includes an adder 732, an attenuating section 734 and a comparing section 736.

Adder 732 receives the points AFT(+) and AFT(-) at which differentiations (the slopes) of the signal are zero, adds the two points and provides an AFT optimal signal to attenuating section 734.

Attenuating section 734 attenuates the AFT optimal signal by a half thereof and provides the same to comparing section 736.

Comparing section 736 compares the AFT optimal signal attenuated at attenuating section 734 with an AFT reference voltage Vref and provides a first processed signal 741 to data processing section 750. At this time, first processed signal 741 is a detected AFT optimal signal about a voltage level of the inputted AFT signal.

Data processing section 750 transforms first processed signal 741 which is an analog signal to a digital signal, preferably, a pulse width modulated (PWM) signal and provides the same to memory 770.

Memory 770 stores the digital signal transmitted from data processing section 750 and prevents an image from swing by using the digital signal stored therein, that is, the AFT optimal data, in an optimal adjust of an image during the channel switch.

In the above described structure, the AFT optimal signal is detected along the voltage level of the AFT signal which is inputted when the AFT optimal signal is stored by the AFT optimizing apparatus. However, when the AFT signal has a relatively long period, a relatively long time is required in detecting the AFT optimal signal.

To solve the above problem, an integrator 738, which integrates voltages 211 at which AFT(+) and AFT(-) are zero and provides a second processed signal 742 which is an AFT optimal signal to data processing section 750, is further provided in AFT optimal signal detecting section 730. That is, when integrator 738 is provided in AFT optimal signal detecting means 730 so as to integrate the signals of AFT(+) and AFT(-), accordingly, a time range of the AFT voltage is compressed, thereby accelerating the AFT optimal signal detecting speed.

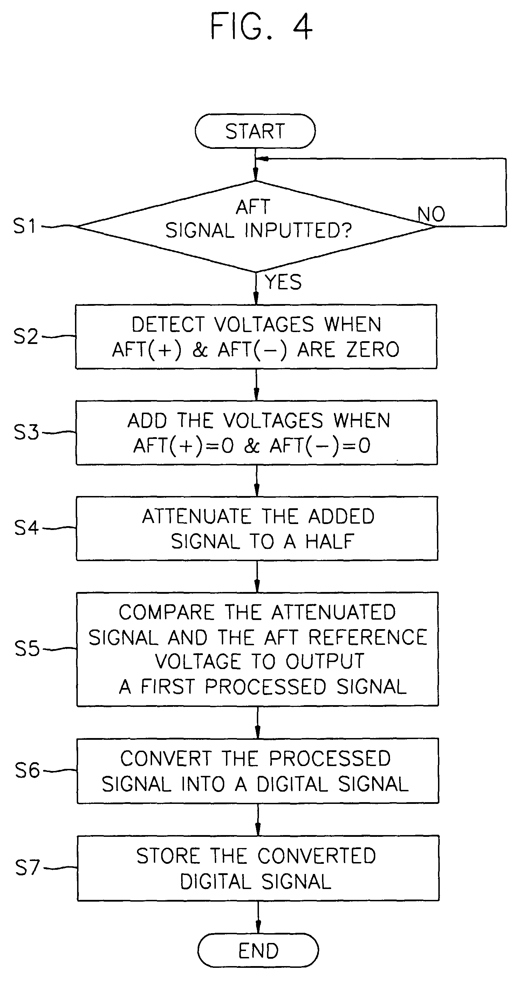

FIG. 4 is a flowchart illustrating an AFT optimal signal memory process by the AFT optimizing apparatus in more detail.

As shown in FIG. 4, at first, the AFT optimizing apparatus determines whether the AFT signal is inputted or not (step S1).

If the AFT signal is inputted, the differentiator (not shown) in detecting section 710 is actuated so as to differentiate the inputted AFT signal and to detect the voltages when the AFT(+) and AFT(-) are zero (step S2).

Then, the voltages of AFT(+) when the AFT(+) is zero and AFT(-) when the AFT(-) is zero and an added signal are outputted (step S3).

Then, the added signal is attenuated to a half thereof and an attenuated signal is outputted (step S4).

Then, the attenuated signal is compared with the AFT reference voltage and a first processed signal 741 is outputted (step S5). At this time, first processed signal 741 is an optimal signal detected along the voltage level of the inputted AFT signal.

Thereafter, first processed signal 741 is converted into a digital signal, preferably, into a pulse width modulated (PWM) signal, and the PWM signal is outputted (step S6), and the PWM signal is stored into memory 770, thereby finishing the AFT optimizing operation (step S7).

Hereinbefore, a case where the AFT optimal signal is detected regarding the voltage level of the AFT signal which is inputted when the AFT optimal signal is stored by the AFT optimizing apparatus is described. However, in a case where when the AFT signal has a relatively long period, a relatively long time is required in detecting the AFT optimal signal, the time range of the AFT signal is compressed and the optimal signal is detected, thereby reducing the time required to detect the AFT optimal data.

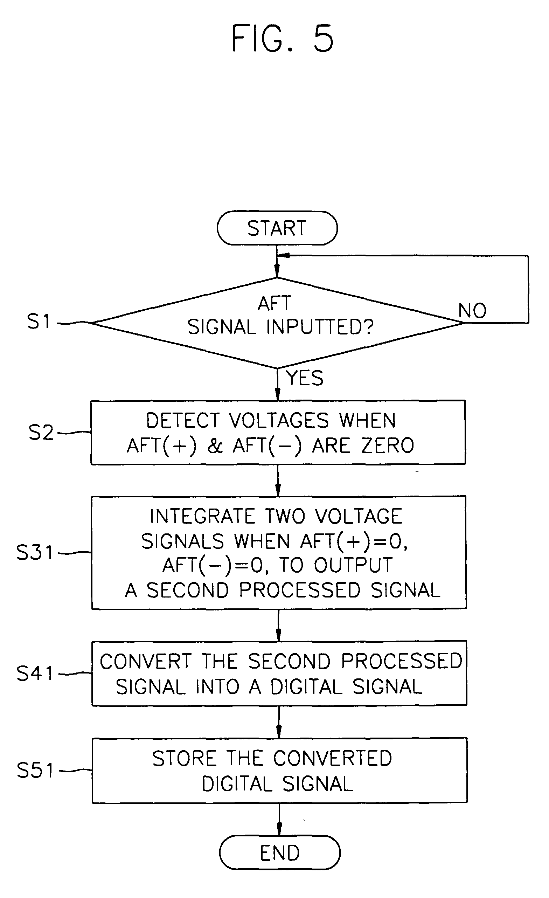

FIG. 5 is a flowchart illustrating a case where the AFT optimal signal is detected by compressing the time range of the AFT signal inputted when the AFT optimal signal is stored by the AFT optimizing apparatus.

As shown in FIG. 5, at first, whether the AFT signal is inputted or not is determined (step S1).

If the AFT signal is inputted, the differentiator (not shown) in detecting section 710 is actuated so as to differentiate the inputted AFT signal and to detect the voltages of AFT(+) when the AFT(+) is zero and AFT(-) when the AFT(-) is zero (step S2).

Then, the voltage signals are integrated between the AFT(+) when the AFT(+) is zero and AFT(-) when the AFT(-) is zero so as to output second processed signal 742 (step S31). At this time, second processed signal 742 is an optimal signal detected along the time range of the inputted AFT signal.

Thereafter, second processed signal 742 is converted into a digital signal, preferably, into a PWM signal, the PWM signal is outputted (step S41), and the PWM signal is stored into memory 770, thereby finishing the AFT optimizing operation (step S51).

Hereinafter, a case where the AFT optimizing method and apparatus therefor are used in the broadcast receiving system which is the television set system or which is a VCR system operated therewith will be briefly described.

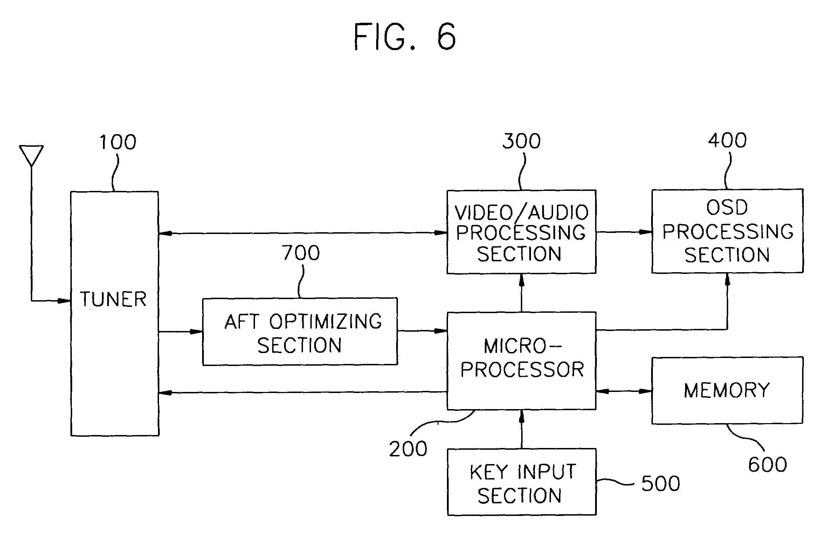

FIG. 6 is a block diagram illustrating a preferred embodiment of a broadcast receiving system adopting the AFT optimizing apparatus according to the present invention.

As shown in FIG. 6, the broadcast receiving system adopting the AFT optimizing apparatus includes a tuner 100, a microprocessor 200, an A/V processing section 300, an OSD processing section 400, a key input section 500, a memory section 600 and an AFT optimizing section 700.

The operation thereof is as follows.

When the user turn on a power, AFT optimizing apparatus 700 detects AFT optimal data of all channels of a broadcasting signal received by tuner 100 and stores the AFT optimal data of each channel into memory section 600.

Then, the AFT is carried out with respect to a selected channel signal which is applied whenever a channel switch is carried out so that an AFT optimal data are overwritten into memory section 600.

Consequently, memory section 600 always stores the optimal AFT data of each channel. When a channel is selected, the stored AFT data is connected so that the channel is switched in a fastest time and the AFT operation is carried out.

Hereinafter, FIG. 6 will be described with reference to FIG. 2 in more detail.

Microprocessor 200 controls a PLL IC (not shown) installed in tuner 100 so as to tune a broadcasting signal of a desired channel. The tuned broadcasting signal is synchronized and is detected at A/V processing section 300 so as to be transmitted to microprocessor 200.

Accordingly, microprocessor 200 detects a visual signal by using a level of the transmitted signal and carries out a channel selecting operation.

At this time, the channel selecting operation starts when the user selects a desired channel and microprocessor 200 outputs a predetermined data, preferably 18-bit data corresponding to the selected channel to a PLL IC (not shown) of tuner 100 and then the PLL IC outputs a local oscillating frequency of the selected channel.

After a predetermined time from the data output, preferably after 50ms, microprocessor 200 detects whether a synchronization signal exists or not based on a synchronization detection signal inputted through a synchronization detection nod so as to determine through which path the operation should be carried out. That is, when microprocessor 200 determines that the synchronization detection signal is high level after the data output, it carries out a synchronization detection operation, while if it determines that the synchronization detecting signal is low level, it carries out a window detection operation.

First, the synchronization operation will be described. Microprocessor 200 carries out a synchronization detection by increasing an initially outputted synchronization voltage one step at each time. When the synchronization signal is not detected after a maximum synchronization check range (5 steps), microprocessor 200 decreases an iniitially outputted voltage one step at each time until detecting the synchronization signal.

During the synchronization detection operation, if the synchronization signal is detected, microprocessor 200 stops the synchronization detection operation and then carries out the window detection operation. However, when the synchronization signal in not detected while sweeping all the steps, microprocessor 200 sends the initially outputted synchronization voltage to the PLL IC of tuner 100 and finishes the channel selecting operation.

Meanwhile, the window detecting operation is carried out as follows.

When the synchronization signal is detected during the synchronization detection operation, microprocessor 200 increases or decreases the synchronization voltage one step at each time based on a position of an AFT signal while checking the AFT signal so as to scan a window of the AFT voltage wave. At this time, when microprocessor 200 searches a window of the AFT voltage wave, it increases or decreases the local oscillating frequency so as to detect the AFT(+) and AFT(-), to carry out an optimal adjusting and to output the data to the PLL IC of tuner 100, thereby finishing the AFT operation and channel selecting operation.

A window setting of the AFT voltage wave for the window detection operation as described above is carried out as follows.

If a voltage level of the initially outputted data is in the critical levels V_{H} and V_{L} of the AFT window, microprocessor 200 increases the local oscillating frequency one step at each time so as to check the AFT signal. At this time, when the AFT(-) is detected, microprocessor 200 increases the frequency one step so as to check the AFT(+). So, if AFT(+) is detected, microprocessor 200 provides data corresponding to the step just before the detection of the AFT(+) to the PLL IC in tuner 100, thereby finishing the channel selecting.

If the voltage level of the initially outputted data is below the critical levels V_{H} and V_{L}, microprocessor 200 determines the voltage level as a low level and accordingly, increases the local oscillating frequency each one step so as to check the AFT(-), so if AFT(-) is detected, it continuously increases the step so as to search the AFT(+), and then decreases each one step so as to search the AFT(-) again. If the AFT(-) is detected, microprocessor 200 provides data of one step just thereof to the PLL IC, thereby finishing the channel selection.

If the voltage level of the initial output data is above the critical levels Vh and Vl, microprocessor 200 determines the voltage level as a high level and accordingly, decreases the local oscillating frequency by one step at each time so as to check the AFT, so if AFT(+) is detected, it continuously decreases the step so as to search the AFT(-), and then increases one step at each time so as to search the AFT(+) again. If the AFT(+) is detected, microprocessor 200 provides data of one step before thereof to the PLL IC, thereby finishing the channel selection.

Meanwhile, after carrying out the above described operations in such a manner that microprocessor 200 increases or decreases the step of the local oscillating frequency, preferably to 5 steps as the maximum, if the AFT(+) and AFT(-) are not detected, it determines that there is no broadcasting signal and provides the initially outputted synchronization voltage to the PLL IC, thereby finishing the channel selection operation.

Meanwhile, an AFT operation to be carried out can be illustrated in two cases as follows, in a case where a temperature variation, characteristic changes of components or an RF frequency of each channel received from the broadcasting station falling out of an allowable range occures after the channel selecting operation is finished so that the AFT voltage is changed.

Firstly, when the RF frequency received is higher than an original channel frequency, and accordingly, the AFT voltage gets out of the AFT window, microprocessor 200 provides data decreased by one step to the PLL IC. Consequently, the local oscillating frequency increases so that the RF frequency change is compensated and the AFT voltage comes into the AFT window.

Secondly, when the RF frequency received is lower than an original channel frequency, and accordingly, the AFT voltage decreases and gets out of the AFT window, microprocessor 200 provides data increased by one step to the PLL IC. Consequently, the local oscillating frequency decreases so that the RF frequency change is compensated and the AFT voltage comes into the AFT window.

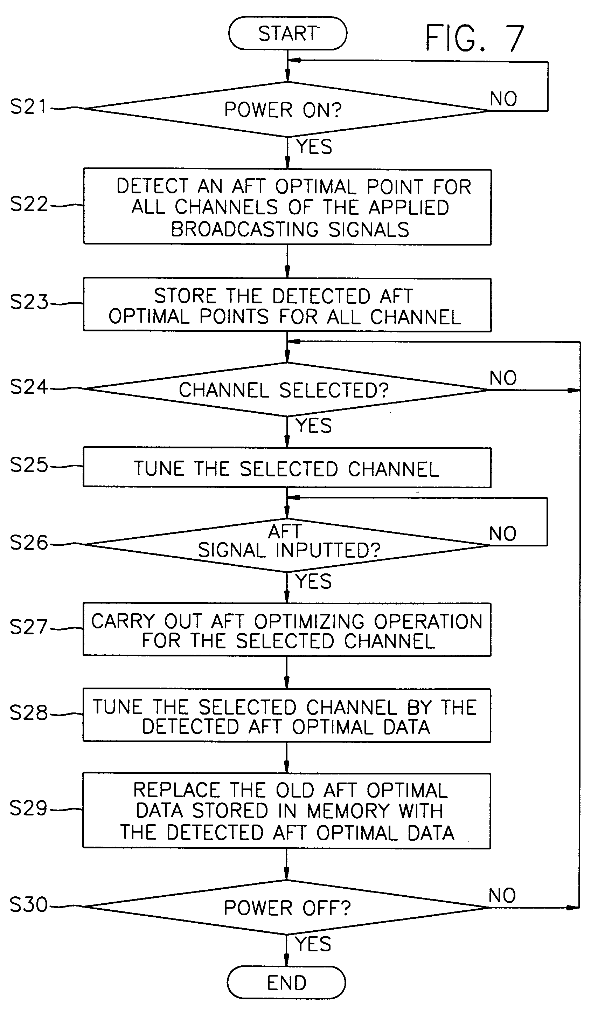

FIG. 7 is a flowchart illustrating the image stabilizing method when the channel is switched in the case where the AFT optimizing apparatus according to the present invention is used in the broadcast receiving system.

As shown in FIG. 7, the image stabilizing method according to the present invention includes a checking step, determining whether the power is turned on or not (step S21).

If, in the step S21, the result is that the power is off, a step S21 is repeated, and if the power is on, the AFT optimal points are detected for all channels of the applied broadcasting signals (step S22).

Then, the detected AFT optimal points data of all channels are stored into the memory (step S23).

Then, whether a channel is selected or not is checked (step S24).

If in the step S24, no channel is selected, the step S24 is repeated, and otherwise, else if a channel is selected, the selected channel is tuned (step S25).

Then, whether or not the AFT signal is inputted is checked (step S26).

If in the step S26, the AFT signal is not inputted, the step S26 is repeated, and if the AFT signal is inputted, the AFT optimizing operation for the selected channel is carried out (step S27).

Then, the selected channel is tuned by an AFT optimal data detected in step S27 (step S28), and an old AFT optimal data stored in the memory is replaced with the detected AFT optimal data (step S29).

Then, if the power is off, the procedure is fedback to step S24 (step S30).

As above described, the AFT optimizing apparatus can be adopted to a broadcast receiving system such as a television receiver system or a VCR system operated therewith. When the channel switch is carried out, since a latest AFT optimal data is already stored in the memory, the channel switching can be quickly conducted and the swing of the image which is usually produced during the channel switch can be avoided.

Although the preferred embodiment of the invention has been described, it is understood that the present invention should not be limited to this preferred embodiment, but various changes and modifications can be made by one skilled in the art within the scope of the invention as hereinafter claimed.

## Claims

1. An automatic fine tuning optimizing method, said method comprising the steps of:
(i) receiving an automatic fine tuning signal;
(ii) detecting a maximum voltage and a minimum voltage of the received automatic fine tuning signal;
(iii) determining an automatic fine tuning optimal signal by data-processing the maximum and minimum voltages detected in step (ii); and
(iv) storing a digital automatic fine tuning optimal signal by digital-processing the automatic fine tuning optimal signal.

2. The automatic fine tuning optimizing method recited in claim 1, wherein said step (iii) comprises the substeps of:
(iii-1) outputting an added signal by adding the maximum and minimum voltages;
(iii-2) outputting an attenuated signal by attenuating the added signal by 2; and
(iii-3) outputting a first processed signal by comparing the attenuated signal with an automatic fine tuning reference voltage.

3. The automatic fine tuning optimizing method recited in claim 2, wherein the first processed signal is an optimal signal detected along a voltage range of the received automatic fine tuning signal.

4. The automatic fine tuning optimizing method recited in claim 1, wherein said step (iii) further comprises an outputting step for outputting a second processed signal by integral processing of the maximum and minimum voltages.

5. The automatic fine tuning optimizing method recited in claim 4, wherein the second processed signal is an optimal signal detected along a time range of the received automatic fine tuning signal.

6. The automatic fine tuning optimizing method recited in claim 1, wherein the digital automatic fine tuning optimal signal is a pulse width modulated signal.

7. An automatic fine tuning optimizing apparatus, said apparatus comprising:
a detecting means for detecting a maximum voltage and a minimum voltage of an automatic fine tuning signal by receiving a tuner input signal;
an automatic fine tuning optimal signal detecting means for detecting an automatic fine tuning optimal signal by receiving the maximum and minimum voltages of the automatic fine tuning signal from the detection means;
a data processing means for data processing the automatic fine tuning optimal signal transmitted from the automatic fine tuning optimal signal detection means into a digital signal; and
a memory for storing the digital signal which is data processed by the data processing means.

8. The automatic fine tuning optimizing apparatus recited in claim 7, wherein the automatic fine tuning optimal signal detecting means is comprised of:
an adding means for adding the maximum and minimum voltages of the Automatic fine tuning signal and outputting an added signal;
an attenuating means for attenuating the added signal by a half thereof and outputting an attenuated signal; and
a comparing means for comparing the attenuated signal generated from the dividing means by an automatic fine tuning reference voltage and outputting a first processed signal.

9. The automatic fine tuning optimizing apparatus recited in claim 7, wherein the automatic fine tuning optimal signal detection means further includes an integrator for integral processing of the maximum and minimum voltages of the automatic fine tuning signal and outputting a second processed signal.

10. The automatic fine tuning optimizing apparatus recited in claim 7, wherein the detecting means includes a differentiator.

11. The automatic fine tuning optimizing apparatus recited in claim 7, wherein the digital signal is a pulse-width modulated signal.

12. An automatic fine tuning method for a broadcast receiving system, which is comprised of:
(I) storing automatic fine tuning optimal data regarding channels detected by carrying out an automatic fine tuning to all channels of a broadcasting signal received when a power is turned on;
(II) tuning a selected channel when a channel switch is carried out;
(III) carrying out an automatic fine tuning optimization to the selected channel when an automatic fine tuning signal is received;
(IV) tuning the selected channel using detected automatic fine tuning optimal data; and
(V) replacing automatic fine tuning optimal data stored in a memory with the detected automatic fine tuning optimal data.
